**Europäisches Patentamt**

**European Patent Office**

**Office européen des brevets**

(19)

(11) Numéro de publication : **0 496 645 A1**

# (12) DEMANDE DE BREVET EUROPEEN

(21) Numéro de dépôt : **92400043.3**

(22) Date de dépôt : **08.01.92**

(51) Int. Cl.⁵ : **H03K 17/95**, F15B 15/28, H03K 17/945, G01B 5/00

(30) Priorité : **11.01.91 FR 9100290**

(43) Date de publication de la demande : **29.07.92 Bulletin 92/31**

(84) Etats contractants désignés :
**CH DE GB IT LI**

(71) Demandeur : **TELEMECANIQUE**
**43-45, Boulevard Franklin Roosevelt**
**F-92500 Rueil Malmaison (FR)**

(72) Inventeur : **Lafaye, Michel**
**6 rue Marcel Pagnol**
**F-16800 Soyaux (FR)**

(74) Mandataire : **Keib, Gérard et al**
**Bouju Derambure (Bugnion) S.A. 38, avenue de la Grande Armée**
**F-75017 Paris (FR)**

(54) **Détecteur de proximité à tête orientable.**

(57)   Le détecteur comprend un boîtier (12), une monture (3) pouvant prendre quatre orientations par rapport au boîtier (12) et une tête détectrice (4) pouvant prendre par rapport à la monture (3) deux orientations dans l'une desquelles une face sensible (29) de la tête est orientée latéralement par rapport à l'axe (Z) du boîtier (12), tandis que dans l'autre orientation la face sensible (29) est centrée sur l'axe (Z).

La monture (3), dissociable du boîtier (12), peut s'engager à travers l'une ou l'autre de deux faces évidées (33, 34) de la tête, par coulissement de glissières (56) de la monture entre un fond (38) et des bossages (43) de la tête. La position d'association de la tête par rapport à la monture est définie par butée de faces (48) des bossages (43) contre des faces de butée (57) de la monture. On fixe ensuite un pivot (18) de la monture dans une ouverture (22) du boîtier.

Utilisation pour supprimer les fixations par vis.

FIG.3

EP 0 496 645 A1

La présente invention concerne un détecteur de proximité dont la tête est orientable de manière que sa face sensible ait une orientation frontale ou au contraire l'une au choix parmi plusieurs orientations latérales.

De tels détecteurs principalement utilisés dans les installations ou machines dans lesquelles il est nécessaire de connaître la position d'une pièce ou objet métallique mobile, peuvent être fixés sur un support ayant, par rapport au déplacement de cet objet, l'une parmi par exemple cinq orientations particulières, l'une correspondant à l'orientation frontale de la face sensible, les autres aux différentes orientations latérales de la face sensible. La fourniture de tels détecteurs est donc avantageuse pour le fabricant, qui peut ainsi rentabiliser sa production, et pour l'utilisateur dans la mesure où il peut ainsi ne disposer que d'un seul stock de détecteurs de rechange.

On connaît déjà, par exemple d'après le DE-U-73 44 278 ou le FR-A-2 608 755, des détecteurs de proximité comprenant un boîtier, une monture pouvant être positionnée sur le boîtier dans plusieurs orientations au choix autour d'un axe et une tête détectrice pouvant être associée à la monture selon deux orientations au choix. Dans l'une de ces deux orientations la face sensible est frontale de sorte que la direction de détection est parallèle audit axe. Dans l'autre des deux orientations précitées, la face sensible est latérale de sorte que la direction de détection est par rapport à l'axe une direction radiale déterminée par l'orientation de la monture autour de l'axe. La tête détectrice a la forme d'un cube avec un évidement pour recevoir la monture.

Selon ces documents, la tête détectrice est fixée à la monture par des vis. Or les fixations par vis prennent de la place dans la tête, surtout que les filetages doivent être relativement longs pour être robustes. Cette longueur de filetage accroît le temps de montage. De plus, si le filetage est endommagé, le montage n'est plus possible.

On connaît encore d'après le FR-A-2 611 264 un détecteur dont la monture en deux parties peut emprisonner la tête dans les différentes orientations prévues. Il n'y a plus de vis entre tête et monture, mais par contre les deux parties de monture sont vissées l'une à l'autre.

Le but de l'invention est ainsi de proposer un détecteur de proximité à tête orientable dans lequel le nombre de fixations par vis est particulièrement réduit.

L'invention vise un détecteur comprenant un boîtier, une monture munie de moyens de positionnement sur le boîtier dans plusieurs orientations au choix autour d'un axe et une tête détectrice cubique qui comporte pour recevoir la monture un évidement affectant deux faces évidées ayant une arête commune et peut être associée à la monture selon deux positions d'association dans chacune desquelles les moyens de positionnement sont adjacents à l'une des faces évidées, destinée à être adjacente au boîtier.

Suivant l'invention, le détecteur est caractérisé en ce que la monture est dissociable du boîtier et, une fois dissociée du boîtier, peut être engagée dans l'évidement par chacune des faces évidées et être déplacée dans l'évidement jusqu'à inter-engagement de moyens de butée de la tête et de la monture qui définissent la position d'association choisie, dans laquelle les moyens de positionnement sont adjacents à la face évidée autre que celle par laquelle la monture a été engagée.

Ainsi, il n'y a plus besoin de vis de fixation pour relier la tête à la monture et la monture n'a pas besoin d'être en plusieurs pièces devant être vissées l'une à l'autre.

Une fois la monture engagée par l'une ou l'autre des deux faces évidées de la tête, selon que la face de détection doit avoir une orientation frontale ou latérale, on déplace la monture dans la tête jusqu'à inter-engagement des moyens de butée. A ce stade, les moyens de positionnement de la monture dans le boîtier sont adjacents à l'autre face évidée de la tête et peuvent être associés au boîtier. Cela réalisé, les moyens de butée empêchent la tête de se déplacer par rapport à la monture dans le sens correspondant à l'engagement précité et l'appui de la tête contre le boîtier empêche le déplacement relatif en sens opposé.

Pour la fixation amovible de la monture au boîtier, on peut avoir recours à diverses solutions dont l'art antérieur donne des exemples.

Mais de préférence, pour réduire encore le nombre de fixations par vis dans le détecteur, les moyens de positionnement s'insèrent entre deux éléments du boîtier et comprennent au moins un épaulement s'appuyant contre une face du boîtier pour empêcher la monture de s'éloigner du boîtier parallèlement à l'axe lorsque les moyens de positionnement sont insérés entre les deux éléments du boîtier.

Ainsi, le simple fait d'associer les deux éléments du boîtier l'un avec l'autre en insérant entre eux les moyens de positionnement de la monture suffit pour retenir la monture en position convenable sur le boîtier.

D'autres particularités et avantages de l'invention ressortiront encore de la description ci-après, relative à des exemples non limitatifs.

Aux dessins annexés :
– la figure 1 est une vue en perspective éclatée d'un détecteur de proximité selon l'invention ;
– la figure 2 est une vue en perspective du détecteur à l'état monté ;
– les figures 3 à 5 sont des vues partielles en perspective visualisant trois étapes du montage de la tête sur la monture, avec arrachements ;
– la figure 6 est une vue en coupe suivant VI-VI de la figure 5 ;

– la figure 7 est une vue de la tête et de la monture à l'état assemblé, en perspective sous un angle différent de celui des figures 3 à 5 ;

– la figure 8 est une vue du détecteur à l'état monté en coupe selon le plan de séparation du corps et du couvercle du boîtier ;

– la figure 9 est une vue partielle semblable à la figure 8 mais dans laquelle le plan de coupe de la tête et de la monture est décalé vers l'observateur ;

– la figure 10 est une vue partielle analogue à la figure 8 mais dans laquelle la face sensible de la tête a son orientation frontale au lieu de latérale ;

– la figure 11 est une vue analogue à la partie supérieure de la figure 1 mais correspondant à un deuxième mode de réalisation ;

– les figures 12 à 15 sont quatre vues en coupe médiane montrant quatre étapes de la mise en place de la tête sur la monture du deuxième mode de réalisation, avec orientation latérale de la face sensible ;

– la figure 16 est une vue en perspective de la tête et de la monture à l'état assemblé ; et

– la figure 17 est une vue analogue à la figure 15 mais avec orientation frontale de la face sensible.

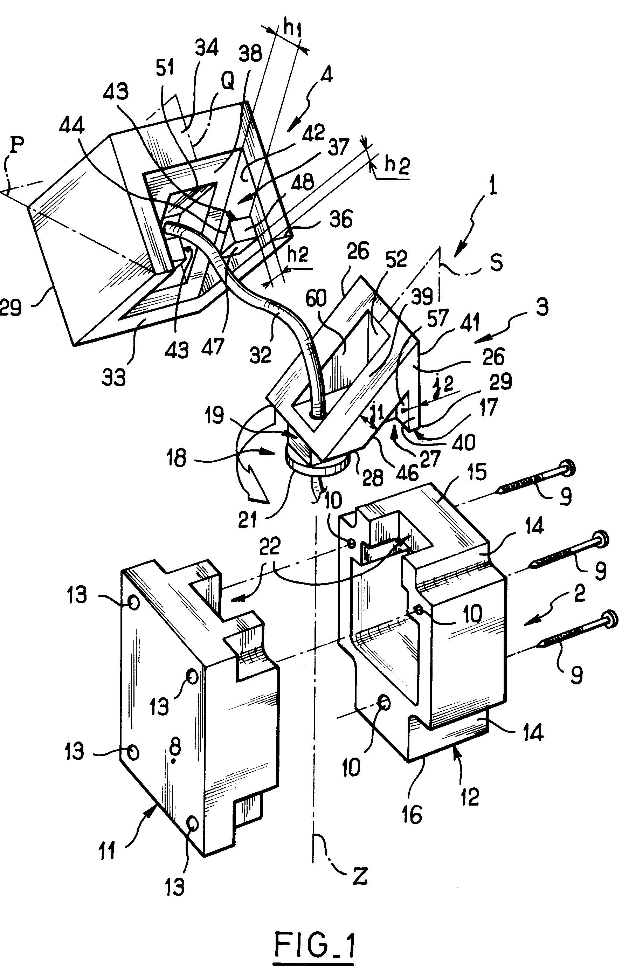

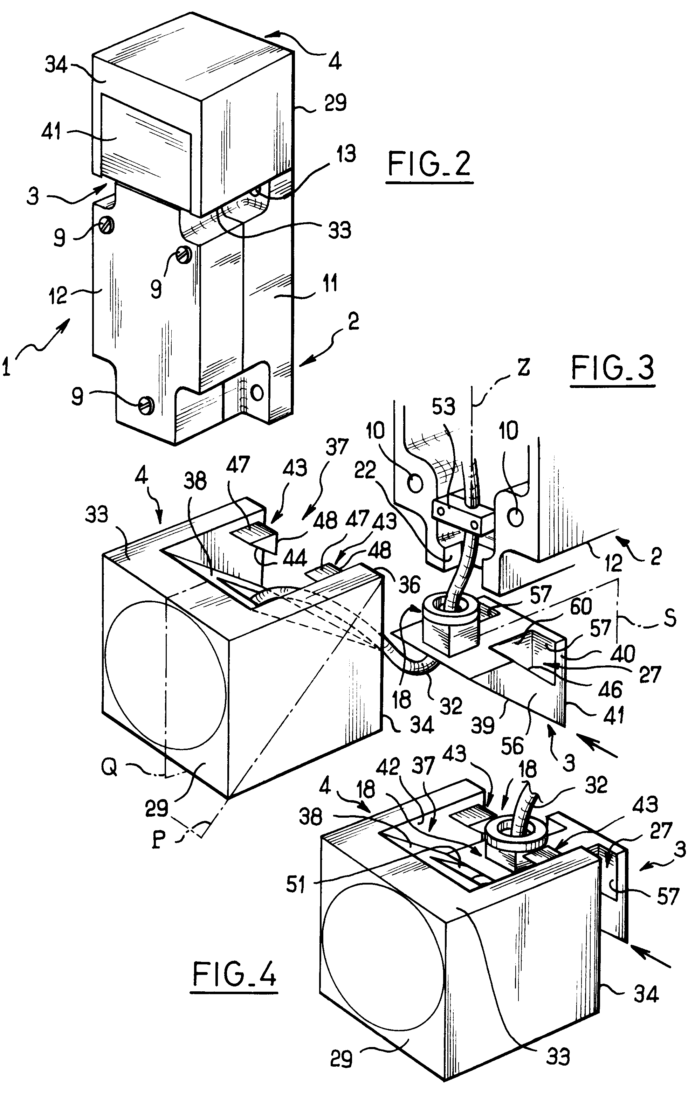

Dans l'exemple représenté aux figures 1 et 2, le détecteur de proximité 1 selon l'invention comporte essentiellement un boîtier 2, une monture de fixation orientable 3 et une tête détectrice 4.

Le boîtier 2 a une forme générale parallélépipédique ayant deux faces d'extrémité 15 et 16 qui sont de forme générale carrée quoique réduite chacune par deux évidements 14. La face d'extrémité 15 est adjacente à la monture 3. Un axe Z du boîtier parallélépipédique traverse orthogonalement les faces 15 et 16 en leur centre.

Le boîtier 2 comporte un corps 11 et un couvercle 12 mutuellement dissociables selon un plan contenant l'axe Z afin de donner accès à un connecteur de raccordement interne, qui n'est pas représenté en raison de sa constitution bien connue. Des vis 9 occupant des canaux parallèles 10 fixent en service le couvercle 12 sur le corps 11. Le corps comprend, pour sa fixation à un support non représenté tel qu'un bâti de machine, des trous 13 s'étendant chacun entre l'un des évidements 14 et une face de base 8 du corps 11, opposée au couvercle 12 et appliquée en service contre le support.

La monture 3 comporte sur sa face de base 17 tournée en service vers la face d'extrémité 15 du boîtier 2, des moyens de positionnement 18 comprenant un pivot 19 de section carrée et d'axe Z, ce pivot 19 s'étendant entre la face 17 et une collerette débordante 21.

Le pivot carré peut être reçu dans une ouverture carrée correspondante 22 ménagée à travers la face d'extrémité 15 du boîtier 2. L'ouverture 22 appartient pour moitié au corps 11 et pour moitié au couvercle 12.

Ainsi, lorsque l'on fixe l'un à l'autre le corps 11 et le couvercle 12, il est possible d'insérer entre eux les moyens de positionnement 18 dans quatre orientations différentes autour de l'axe Z, et ainsi de donner à la monture 3 l'une au choix de quatre orientations différentes autour de l'axe Z par rapport à la face de base 8 du corps 11.

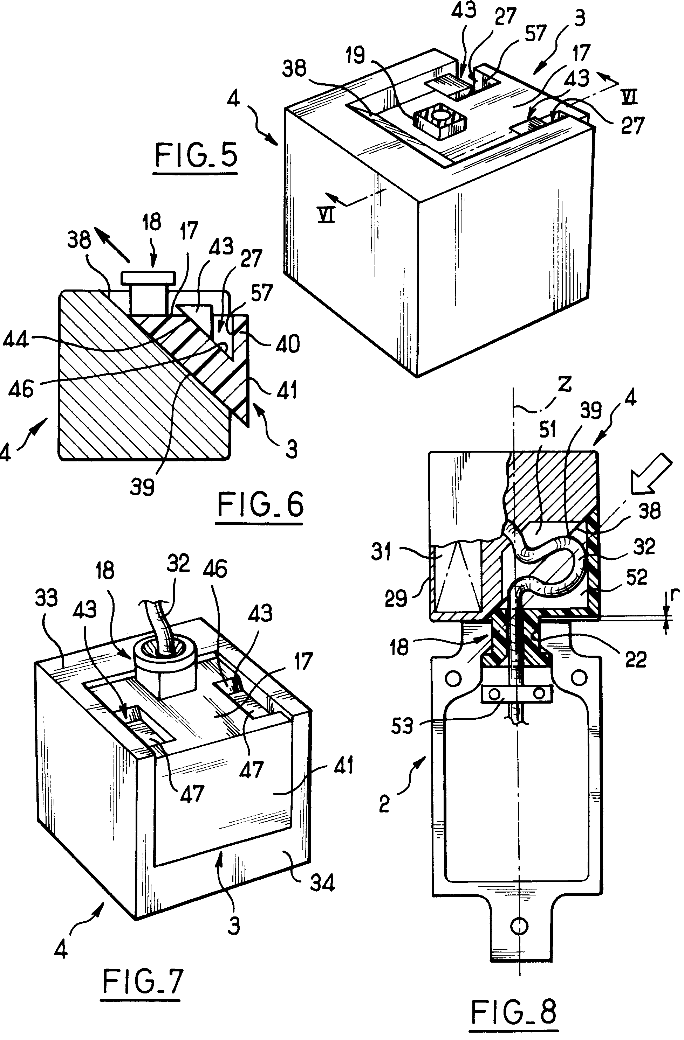

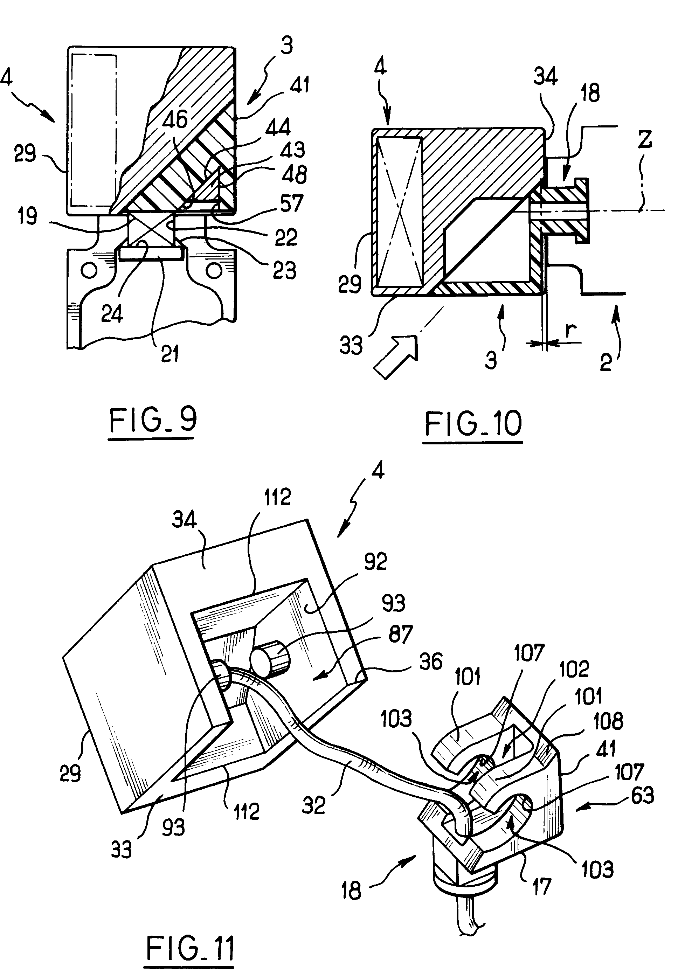

Comme le montrent les figures 8 et 9, l'ouverture 22 du boîtier 2 débouche, vers l'intérieur du boîtier 2, à travers une surface tronconique 23. Un épaulement plan 24 de la collerette 21 s'appuie sur la surface tronconique 23 tandis que le pivot carré 19 est emboîté de manière étroite dans l'ouverture 22.

La forme tronconique de la surface 23 a, par rapport à une surface qui serait plane et perpendiculaire à l'axe Z, l'avantage de permettre d'engager facilement la collerette 21 sous cette surface lorsqu'on approche l'un de l'autre le corps 11 et le couvercle 12. A la suite de cela, le rapprochement mutuel du corps 11 et du couvercle 12 par serrage des vis 9 produit, par l'intermédiaire de cette face tronconique, une traction sur les moyens de positionnement 18 parallèlement à l'axe Z vers l'intérieur du boîtier, de manière à rattraper les jeux et tolérances entre le boîtier 2 et l'ensemble constitué par la monture 3 et la tête 4.

Comme le montre la figure 1, la monture 3 a une forme générale prismatique ayant deux faces d'extrémité opposées 26 ayant une forme générale de triangle isocèle rectangle. Deux arêtes opposées 28 de la face de base 17 de la monture 3 constituent chacune l'un des côté de l'angle droit 29 de l'une des faces 26. Chaque arête 28 est interrompue par un évidement prismatique 27 débouchant dans la face 17 et dans l'une des faces 26, et dont les faces de prisme sont parallèles à celles de la monture 3. Deux glissières 56 sont délimitées chacune entre la face de prisme oblique 39 de la monture 3 et la face de prisme oblique 46 de l'un des évidements 27.

La tête détectrice 4 est de forme générale cubique. Comme le montre la figure 8, elle renferme derrière l'une de ses faces, appelée face sensible 29, un dispositif tel qu'un bobinage 31, dont le comportement électrique varie lorsqu'un objet métallique passe devant la face sensible 29. Ce genre de dispositif, de même que la façon de le monter dans une tête de forme générale cubique telle que la tête 4 sont bien connus et ne seront pas décrits en détail. On rappellera simplement que le dispositif 31 doit être relié avec l'intérieur du boîtier 2 par un fil 32 servant à l'alimentation du dispositif 31 et à l'acheminement des signaux fournis par le dispositif 31.

Revenant à la figure 1, la tête 4 comporte en outre deux faces évidées 33 et 34 dont l'une, 33, est adjacente à la face 29 et l'autre, 34, est opposée à la face 29. Les faces 33 et 34 ont une arête commune 36, laquelle est interrompue par un évidement 37 qui a une forme générale prismatique sensiblement de mêmes dimensions et de même configuration que la forme générale prismatique de la monture 3.

Ainsi, l'évidement 37 a un fond oblique 38 ayant un profil rectiligne orienté à 45° par rapport aux faces évidées 33 et 34 et qui correspond à une face oblique 39 de la monture 3 qui a un profil rectiligne correspondant, c'est-à-dire est disposée à 45° par rapport à la face 17 et à une face de fermeture 41 de la monture 3.

L'évidement 37 a en outre deux faces d'extrémité 42 opposées en forme de triangle isocèle rectangle, situées dans des plans perpendiculaires à l'arête commune 36, et qui correspondent aux faces d'extrémité 26 de la monture 3.

Les faces d'extrémité 42 portent chacune des moyens de butée comprenant un bossage prismatique 43 ayant des faces de prisme parallèles aux faces de prisme de l'évidement 37 avec une face oblique 44 située en face du fond 38. La distance h1 entre la face oblique 44 et le fond 38 est sensiblement égale à la distance j1 entre la face oblique 39 de la monture 3 et la face oblique parallèle 46 des évidements 27. Chaque bossage 43 comporte en outre deux faces orthogonales 47 et 48 qui sont parallèles aux faces 33 et 34 respectivement et décalées par rapport à celles ci, vers l'intérieur de l'évidement 37, d'une distance h2 égale à l'épaisseur j2 de deux parois 40 qui contribuent à définir la face de fermeture 41 et au dos desquelles sont formées les faces 57 des évidements 27 qui sont parallèles à la face de fermeture 41. Les bossages 43 sont disposés en regard l'un de l'autre et à distance l'un de l'autre.

En outre, le fond 38 et la face oblique 39 de la monture 3 et de l'évidement 37 comportent chacun un logement 51, 52 pour recevoir une certaine longueur du fil 32 lequel, en provenance du dispositif 31 (figure 8), traverse le plan commun des faces 38 et 39 et traverse de manière coulissante les moyens de positionnement 18 jusqu'à un serre-câble 53 disposé à l'intérieur du couvercle 12.

Compte-tenu de ce qui vient d'être décrit, il ressort que l'évidement 37 et les bossages 43 sont symétriques par rapport à un plan P (figure 1) contenant l'arête 36 et bissecteur des faces évidées 33 et 34 et aussi par rapport à un plan médian Q du cube de la tête 4, le plan Q étant perpendiculaire à l'arête 36. La monture 3 est elle-même symétrique par rapport à un plan S parallèle aux faces 26 et équidistant entre elles.

On va maintenant décrire le mode d'assemblage du détecteur, qui constitue en même temps le mode de sélection de l'orientation de la face sensible 29 par rapport à la face de base 8 du corps 11 du boîtier 2.

Comme le montre la figure 3, on présente la monture 3 en face de l'une 34 des faces évidées 33 et 34 de la tête 4. Dans l'exemple représenté, où on souhaite que la face sensible 29 ait une orientation latérale, on présente la monture 3 en regard de la face évidée 34 opposée à la face sensible 29. Compte-tenu de la symétrie par rapport au plan P, il est évident qu'on pourrait retourner de 180° la tête 4 de façon à intervertir les positions des faces 33 et 34 sans rien changer à ce qui va être exposé, sauf que la face sensible 29 serait perpendiculaire à l'axe Z au lieu d'être parallèle à celui-ci, de manière à donner à la face sensible une orientation frontale au lieu de latérale.

La monture 3 est présentée de façon que sa face oblique 39 soit sensiblement dans le même plan que le fond 38 de l'évidement 37 et de manière que les faces obliques 46 des évidements 27 soient alignées avec les faces obliques 44 des bossages 43.

A partir de cette situation, comme représenté à la figure 4, on déplace la monture 3 par rapport à la tête 4 selon une direction parallèle au fond 38 de l'évidement 37 pour engager les glissières 56 entre le fond 38 et les faces 44. Les glissières 56 coulissent entre le fond 38 et les faces 44 tandis que les moyens de positionnement 18, emmenant avec eux le fil 32, passent entre les faces d'extrémité, espacées l'une de l'autre, des bossages 43. Ce coulissement a lieu jusqu'à ce que, comme représenté aux figures 7 et 8, les faces 57 des évidements 27 viennent buter contre les faces 48 des bossages 43. Ainsi, les faces 57 et les bossages 43 constituent des moyens de butée qui limitent la course de coulissement de la monture 3 à travers la tête 4. Comme le montrent les figures 2 et 7 à 9, dans cette position dite "position d'association", la face de fermeture 41 est sensiblement dans le même plan que la face évidée 34 éloignée des moyens 18, et ferme sensiblement la face 34. Par contre, la face de base 17 de la monture 3 présente un léger retrait r (figure 8) par rapport à la face évidée 33 de la tête 4. De plus, des parois latérales 60 du logement 52 sont situées entre les bossages 43.

A ce stade, on place les moyens de positionnement 18 entre le corps 11 et le couvercle 12 non encore assemblés, et on assemble le corps 11 et le couvercle 12 au moyen des vis 9 ce qui, compte-tenu de l'effet de la surface tronconique 23 (figure 9), tire l'ensemble monture 3-tête 4 contre la face 15 du boîtier 2 et appuie par conséquent contre celle-ci la face évidée 33 de la tête 4 puisque la face de base 17 de la monture 3 est en retrait par rapport à la face évidée 33. De la sorte, la tête 4 est fermement serrée contre la face 15 et la tête est immobilisée par rapport au boîtier 2.

Plus particulièrement, les faces d'extrémité 42 de l'évidement 37 de la tête 4 sont appuyées contre les faces d'extrémité 26 de la monture 3, ce qui empêche la tête de se déplacer latéralement et aussi de tourner autour de l'axe Z par rapport à la monture. L'appui mutuel des faces 33 et 15 empêche également la tête de tourner autour de tout autre axe et la tête ne peut pas non plus se déplacer parallèlement à l'arête 28 de la monture compte-tenu de l'appui du fond 38 de l'évidement contre la face 39 et des faces obliques 44 des bossages 43 contre les faces obliques 46 des évidements 27.

Le guidage coulissant entre la tête et la monture selon une direction à 45° par rapport à la face 33 d'appui sur le boîtier 2 se fait par appui de grande longueur entre le fond 38 et la face oblique 39 ce qui empêche la monture de pivoter légèrement par rapport à la tête autour d'un axe parallèle à l'arête commune 36 sous l'effet de la traction exercée sur les moyens de positionnement 18.

Finalement, la tête 4, à partir de sa position d'association, est strictement guidée en coulissement oblique parallèle au fond 38 par rapport à la monture 3 mais, une fois l'ensemble tête-monture fixé au boîtier, ce coulissement est empêché, dans un sens par butée mutuelle des bossages 43 et des faces de butée 57 et, dans l'autre sens, par appui mutuel des faces 33 et 15.

L'épaulement 24 de la collerette 21 empêche la monture 3 et par conséquent la tête 4 de s'éloigner du boîtier selon l'axe Z. La monture ne peut pas non plus se rapprocher du boîtier, compte-tenu de l'appui entre les faces obliques 44 des bossages 43 et les faces obliques 46 des évidements 27. De plus, la forme carrée du pivot 19 emboîté dans l'ouverture carrée correspondante 22 du boîtier 2 empêche la monture et la tête de tourner, en particulier autour de l'axe Z, et de se déplacer latéralement.

Compte-tenu de tout ce qui précède, le montage est tel que les quatre constituants qui sont le corps 11, le couvercle 12, la monture 3 et la tête 4 sont fermement immobilisés les uns par rapport aux autres lorsque les vis 9 sont serrées.

Par l'emploi de moyens de butée 43 symétriques par rapport au plan Q (figure 3), et espacés de part et d'autre de ce plan, on assure un appui stable entre la monture 3 et la tête 4 tout en permettant au fil 32 de circuler entre les bossages 43 lors du montage.

Comme le montre la figure 10, et comme déjà annoncé plus haut, on peut engager la monture 3 à travers la face évidée 33 qui est adjacente à la face sensible 29 de manière que les moyens de positionnement 18 soient ensuite adjacents à la face évidée 34 opposée à la face sensible 29 qui a alors par rapport au boîtier 2 une orientation frontale. Dans ce cas, de manière non représentée, ce seront les faces 47, et non plus les faces 48, des bossages de butée 43 qui buteront contre les faces de butée 57 de la monture 3 pour limiter le coulissement de la monture 3 à travers la tête 4 lorsque la position d'association est atteinte.

Le mode de réalisation des figures 11 à 17 ne sera décrit qu'en ce qui concerne ses différences par rapport au précédent.

La monture 63 a la forme générale d'une équerre dont l'une des ailes porte sur sa face extérieure -ou face de base- 17 les moyens de positionnement 18 inchangés, et l'autre aile porte à l'extérieur la face de fermeture 41 également inchangée et, du côté intérieur, deux crochets parallèles 101 définissant entre eux un logement 102 pour le fil 32. Les crochets 101 entourent partiellement des gorges 103 dont le fond 107 forme un moyen de butée.

L'évidement 87 a des faces d'extrémité 92 en forme de pentagone qui portent comme moyens d'accrochage et de butée deux bossages cylindriques opposés et espacés 93 dont chacun est destiné à être reçu par l'une des gorges 103.

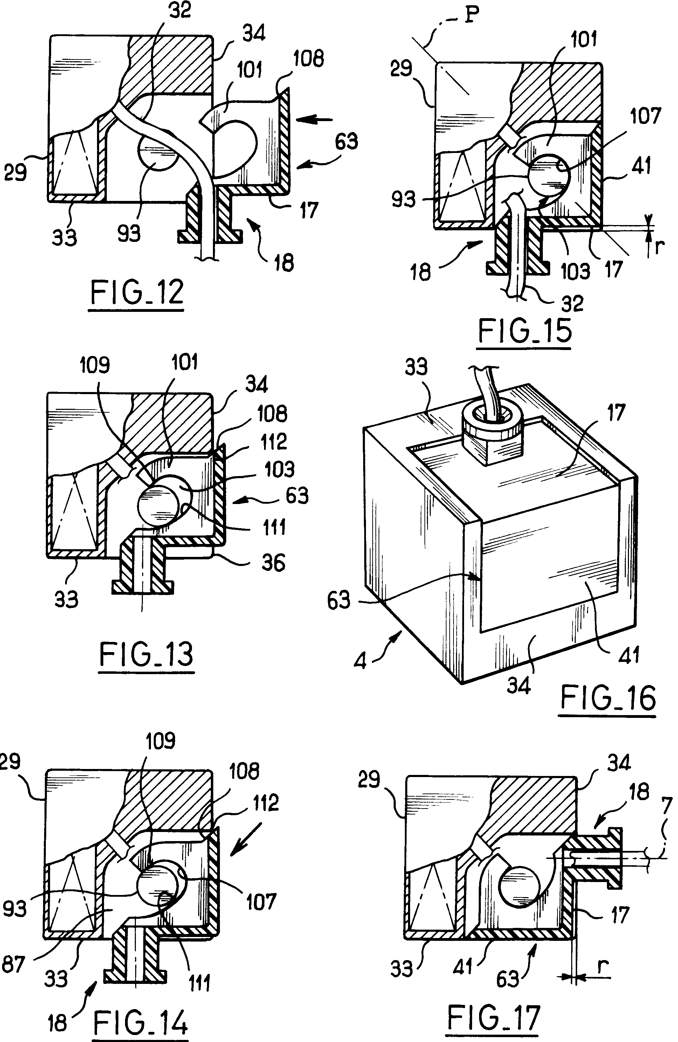

Comme le montre la figure 12, pour l'assemblage on engage comme dans l'exemple précédent la monture 63 à travers la face évidée 34 autre que celle 33 devant être adjacente aux moyens de positionnement 18 compte-tenu de l'orientation, latérale dans ce cas, voulue pour la face sensible 29. On engage les crochets 101 derrière les bossages 93 par un mouvement perpendiculaire à la face évidée d'entrée 34 jusqu'à ce qu'une face oblique 108, orientée à 45°, de la monture 63 bute contre le bord 112, parallèle à l'arête commune 36 (figure 13), de l'évidement 87. A ce stade, chaque bossage 93 est en regard de la gorge 103 du crochet 101 correspondant et le bossage 93 peut coulisser entre une face à 45° 109 du crochet 101 et une face 111 ménagée sur la monture 63 parallèlement à la face 109 et en regard de celle-ci.

Ainsi, comme représenté à la figure 14, l'étape suivante est un déplacement à 45° moyennant coulissement du bossage 93 entre les faces 109 et 111 et glissement de la face 108 contre le bord 112 de l'évidement 87. Ce mouvement de coulissement selon une direction formant un angle par rapport à la face évidée 33 à laquelle les moyens de positionnement 18 doivent finalement être adjacents, se poursuit jusqu'à ce que les bossages 93 (figure 15) butent contre les surfaces de butée 107 au fond des gorges 103.

A ce stade, la position d'association est atteinte, comme représenté à la figure 16. Dans celle-ci, comme dans l'exemple précédent, la face de fermeture 41 est dans le plan de la face évidée correspondante 34 de la tête 4 tandis que la face de base 17 est en léger retrait par rapport à l'autre face évidée 33.

L'association entre l'assemblage tête/monture ainsi réalisée et le boîtier 2 non représenté s'effectue comme dans l'exemple précédent.

La figure 16 montre que dans cet exemple de réalisation, la face de base 17 n'est pas affectée par des évidements tels que les évidements 27 de la figure 1.

Comme représenté à la figure 17, il est là encore possible d'engager la monture 63 à travers la face évidée 33 pour que les moyens de positionnement 18 soient finalement adjacents à la face évidée 34 de manière que la face sensible 29 ait sont orientation frontale.

Bien entendu, l'invention n'est pas limitée aux exemples décrits et représentés.

On pourrait par exemple prévoir un accrochage plus simple entre la tête et la monture, tandis que certains moyens d'immobilisation de la tête seraient obtenus par coopération de conformations appropriées de la tête et du boîtier, en particulier pour empêcher les mouvements latéraux de la tête par rapport au boîtier.

## Revendications

1. Détecteur de proximité comprenant un boîtier (2), une monture (3, 63) munie de moyens de positionnement (18) sur le boîtier (2) dans plusieurs orientations au choix autour d'un axe (Z) et une tête détectrice cubique (4) qui comporte pour recevoir la monture un évidement (37, 87) affectant deux faces évidées (33, 34) ayant une arête commune (36) et peut être associée à la monture (3, 63) selon deux positions d'association dans chacune desquelles les moyens de positionnement (18) sont adjacents à l'une des faces évidées (33, 34), destinée à être adjacente au boîtier (2), caractérisé en ce que la monture (3, 63) est dissociable du boîtier (2) et, une fois dissociée du boîtier, peut être engagée dans l'évidement (37, 87) par chacune des deux faces évidées (33, 34) et être déplacée dans l'évidement jusqu'à inter-engagement de moyens de butée (43, 57 ; 93, 107) de la tête (4) et de la monture (3, 63) qui définissent la position d'association choisie, dans laquelle les moyens de positionnement (18) sont adjacents à la face évidée (34, 33) autre que celle (33, 34) par laquelle la monture a été engagée.

2. Détecteur selon la revendication 1, caractérisé en ce que les moyens de positionnement (18) s'insèrent entre deux éléments (11, 12) du boîtier (2) et comprennent au moins un épaulement (24) s'appuyant contre une face (23) du boîtier (2) pour empêcher la monture (3, 63) de s'éloigner du boîtier parallèlement à l'axe (Z) lorsque les moyens de positionnement (18) sont insérés entre les deux éléments (11, 12) du boîtier.

3. Détecteur selon la revendication 2, caractérisé en ce que l'épaulement (24) est porté par une collerette d'extrémité (21) des moyens de positionnement (18).

4. Détecteur selon l'une des revendications 1 à 3, caractérisé en ce que la monture (3, 63) comporte au voisinage des moyens de positionnement (18) une face (15) qui, lorsque les moyens de butée (43, 57 ; 93, 107) sont inter-engagés, est en retrait (r) par rapport à la face évidée (33) à laquelle les moyens de positionnement (18) sont adjacents.

5. Détecteur selon l'une des revendications 1 à 4, caractérisé en ce que l'évidement (37, 87) interrompt l'arête commune (36) et en ce qu'un fil de liaison (32) entre le boîtier (2) et la tête (4) est guidé à travers la monture (3, 63).

6. Détecteur selon l'une des revendications 1 à 5, caractérisé en ce que les moyens de butée (43, 93) de la tête (4) sont disposés symétriquement de part et d'autre d'un plan (Q) perpendiculaire à l'arête commune (36).

7. Détecteur selon l'une des revendications 1 à 6, caractérisé en ce que l'évidement (37, 87) et la monture (3, 63) comportent des faces d'appui mutuel (42, 26 ; 92) qui empêchent la tête (4) de se déplacer par rapport à la monture (3, 63) parallèlement à l'arête commune (36) lorsque la tête est en position d'association sur la monture.

8. Détecteur selon l'une des revendications 1 à 7, caractérisé en ce que la tête (4) et la monture (3, 63) comportent des moyens de guidage mutuel (38, 39 ; 44, 46 ; 108, 112 ; 109, 111, 93) qui sont opérants au moins au voisinage de la position d'association pour ne permettre à la tête, par rapport à la monture, qu'un mouvement dirigé selon un angle par rapport à la face évidée (33, 34) à laquelle les moyens de positionnement (18) sont adjacents.

9. Détecteur selon la revendication 8, caractérisé en ce que l'angle est sensiblement égal à 45°.

10. Détecteur selon l'une des revendications 8 ou 9, caractérisé en ce que les moyens de guidage mutuel (38, 39 ; 44, 46 ; 108, 112 ; 109, 111, 113) sont agencés pour empêcher la tête de pivoter par rapport à la monture autour d'un axe parallèle à l'arête commune (36).

11. Détecteur selon l'une des revendications 8 à 10, caractérisé en ce que dans son mouvement d'engagement et de déplacement dans la tête (4) la monture (3) est guidée de manière coulissante entre un fond (38) de l'évidement et les moyens de butée (43) de la tête.

12. Détecteur selon la revendication 11, caractérisé en ce que le fond (38) de l'évidement (37) a un profil longitudinal rectiligne orienté à 45° par rapport aux faces évidées (33, 34) et pendant l'engagement et le déplacement, la monture (3) s'appuie sur le fond (38) de l'évidement par une face (39) ayant un profil longitudinal rectiligne correspondant.

**13.** Détecteur selon la revendication 12, caractérisé en ce que les moyens de butée (43) de la tête (4) ont un profil en forme de triangle isocèle rectangle avec une face (44) parallèle au fond (38).

**14.** Détecteur selon l'une des revendications 11 à 13, caractérisé en ce que les moyens de butée (57) de la monture (3) sont aménagés au dos d'une paroi (40) contribuant à définir une face de fermeture (41) qui se positionne dans le plan de la face évidée (34, 33) éloignée des moyens de positionnement (18) et ferme sensiblement cette dernière lorsque la tête (4) est en position d'association sur la monture.

**15.** Détecteur selon l'une des revendications 11 à 14, caractérisé en ce que les moyens de butée de la tête comprennent deux bossages (43) dirigés l'un vers l'autre dans l'évidement (37) et entre lesquels s'étend une partie (60) de la monture (56) lorsque la tête est en position d'association sur la monture.

**16.** Détecteur selon l'une des revendications 1 à 10, caractérisé en ce que la monture (63) a la forme générale d'une équerre dont l'une des ailes porte les moyens de positionnement (18) sur sa face extérieure (15) et l'autre aile porte sur sa face intérieure un moyen d'accrochage (101) portant au moins en partie les moyens de butée (107) de la monture et destiné à coopérer avec un moyen d'accrochage complémentaire (93) prévu dans l'évidement (87).

**17.** Détecteur selon l'une des revendications 1 à 10, caractérisé en ce que la monture (63) à la forme générale d'une équerre dont l'une des ailes porte les moyens de positionnement (18) sur sa face extérieure (15) et l'autre aile porte sur sa face intérieure deux moyens d'accrochage (101) portant au moins en partie les moyens de butée (107) de la monture (63) et destinés à coopérer avec deux moyens d'accrochage complémentaires (93) prévus dans l'évidement (87), les moyens d'accrochage étant mutuellement espacés pour ménager entre eux un logement (102) de réception du fil de liaison (32) allant de la monture (63) à la tête (4).

# FIG. 1

FIG_2

FIG_3

FIG_4

FIG.5

FIG.6

FIG.7

FIG.8

FIG. 9

FIG. 10

FIG. 11

FIG_12

FIG_15

FIG_13

FIG_16

FIG_14

FIG_17

EP 0 496 645 A1

Office européen
des brevets

# RAPPORT DE RECHERCHE EUROPEENNE

Numero de la demande

EP 92 40 0043

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 654 471 (OMRON TATEISI ELECTRONICS CO) | 1-12,14,15 | H 03 K 17/95 |
| A | * en entier * | 13,16-18 | F 15 B 15/28 |
| | | | H 03 K 17/945 |
| | --- | | G 01 B 5/00 |
| Y | EP-A-0 015 497 (E.SCHMIDT) * page 2, ligne 26 - page 8; revendications 1-14; figures 1-4 * | 1-12,14,15 | |
| | --- | | |
| D,A | FR-A-2 611 264 (LA TELEMECHANIQUE ELECTRIQUE) * en entier * | 1-18 | |
| | --- | | |
| A | US-A-4 785 240 (SQUARE D COMPANY) * en entier * | 1-18 | |
| | --- | | |
| D,A | FR-A-2 608 755 (LA TELEMECHANIQUE ELECTRIQUE) * en entier * | 1,4-8,10,12,14 | |
| | --- | | DOMAINES TECHNIQUES RECHERCHES (Int. Cl.5) |
| A | US-A-4 704 524 (OMRON TATEISI ELECTRONICS CO) * en entier * | 1-3 | |
| | --- | | H 03 K |
| | | | F 15 B |
| | | | G 01 B |

Le présent rapport a été établi pour toutes les revendications

| Lieu de la recherche | Date d'achèvement de la recherche | Examinateur |
|---|---|---|
| LA HAYE | 23-04-1992 | BROCK T.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

13